# EUROPEAN PATENT APPLICATION

(11) **EP 2 226 842 A1**
(43) Date of publication of application: **08.09.2010**
(21) Application number: 10000637.8
(22) Date of filing: 22.01.2010
(51) Int. Cl.: H01L 23/367, H01L 33/64

(54) **Thermal conduction structure for heat generating components**

(30) Priority: 06.03.2009 TW 98203412 U
(71) Applicant: ACPA Energy Conversion Devices Co., Ltd., Jhonghe City (Taipei County 23552) (TW)
(72) Inventor: Yao, Pei-Chih, Taipei County 23552 (TW)
(74) Representative: Zeitler - Volpert - Kandlbinder

(57) **Abstract**

A thermal conduction structure for heat generating components includes a heat conduction base 10, a heat conduction module 20 having a plurality of heat columns 21 installed on the heat conduction base 10, and a plurality of heat generating components 30 installed on a distal surface of the heat column 21. Each heat column 21 includes at least one heat generating component 30, and heat produced by the heat generating components 30 is passed from the heat column 21 to the heat conduction base 10 for shunting, conducting and dissipating the heat, such that the heat produced by the heat generating component 30 can be conducted, shunted and dissipated quickly to achieve an excellent thermal conduction effect to prevent a high-heat area or a thermal interference area formed on an installation surface of the heat generating component 30, so as to assure a normal operation and a long using life of the heat generating components 30.

## Description

### BACKGROUND OF THE INVENTION

### Field of the Invention

The present invention relates to a thermal conduction structure for heat generating components, and more particularly to an improved thermal conduction structure having an excellent thermal conduction and shunt path.

### Description of the Related Art

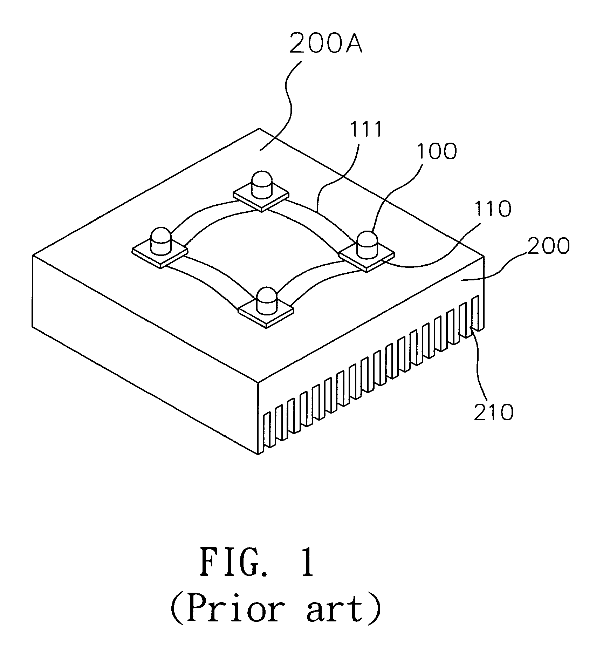

As computer and consumer electronic products advance, microprocessors generally come with an increasingly higher speed, and heat produced by the products become increasingly larger accordingly. Similarly, illumination equipments are designed and developed in compliance with strict environmental protection and energy crisis related regulations and laws, and the development of light emitting diodes (LED) plays an important role in the illumination industry. Since LED has the advantages of a higher efficiency, a better power saving effect, a longer life expectance, a quicker response, a more consistent color uniformity and an additional luminescence over conventional light sources, therefore the development of LED applied in the illumination equipments has become a main subject of the optoelectronic and illumination industries, and LED gradually leads and replaces the position of other conventional light sources in the industry. However, the life expectancy, function, and heat dissipation efficiency of a product, regardless of a computer product or an electronic consumer product, are closely correlated. As to a light source (such as an LED) as shown in FIG. 1, a thermal conduction structure comprises a heat sink 200 having an installation surface 200A, a plurality of LEDs 100 installed on the installation surface 200A and electrically coupled to an electric circuit 111, and a plurality of fins 210 installed on another side of the installation surface 200A of the heat sink 200 for eliminating a heat source of the fins 210. Although the thermal conduction structure of the LED has the heat dissipation effect to a certain extent, yet the installation surface 200A spreading the most of all heat sources including the heat generated by the LED 100 and related electronic devices (not shown in the figure) is a high heat concentrated area, and a large quantity of heat cannot be conducted or eliminated immediately. Furthermore, the heat is generated continuously, particularly by the densely distributed LEDs, so that the installation surface 200A usually becomes a heat distributing area and affects the heat dissipation effect as well as the functions and the life of the LEDs 100. Obviously, such design is not good enough and requires further improvements. Therefore, it is an important subject for related manufacturers to overcome the shortcomings of the conventional thermal conduction structure for the heat generating components.

In view of the description above, the inventor of the present invention based on years of experience in the related industry to conduct extensive researches and experiments, and finally developed a thermal conduction structure for heat generating components in accordance with the present invention.

### Summary of the Invention

Therefore, it is a primary objective of the present invention to overcome the shortcomings of the prior art by providing a thermal conduction structure for heat generating components, and the thermal conduction structure can conduct and dissipate heat quickly, and then collect and spread the heat at a far end, and the thermal conduction structure forms a unique thermal conduction and shunt path to achieve an excellent heat dissipation effect.

Another objective of the present invention is to provide a thermal conduction structure for heat generating components for preventing a high-heat area or a thermal interference area from being formed on an installation surface of the heat generating components to assure the functions and life of the heat generating components.

To achieve the foregoing objective, the present invention provides a thermal conduction structure, comprising: a heat conduction base; a heat conduction module, including a plurality of heat columns, installed on the heat conduction base; and a heat generating component, installed on a distal surface of the heat column, such that heat produced by the heat generating component can be passed to the heat column for shunting, conducting and dissipating the heat.

To achieve the foregoing objective, the present invention provides a thermal conduction structure further comprising a plurality of heat generating components installed onto a distal surface of each corresponding heat column, wherein the heat column is in a long or flat cylindrical shape.

The effects of the thermal conduction structure of the present invention reside on that the heat columns are installed with a gap apart from each other, so that a minor portion of the heat source produced by the heat generating component is dissipated and eliminated by the heat columns, and a major portion of the heat source is shunt and conducted continuously from the heat columns to the heat conduction base, and finally the heat source is dissipated and eliminated by the heat conduction base. As a result, the heat source produced by the heat generating component can be shunted and conducted quickly, and then collected and spreaded at a far end to constitute a unique heat shunt and conduction path, so as to achieve an excellent heat dissipation effect.

To make it easier for our examiner to understand the objective of the invention, its structure, innovative features, and performance, we use a preferred embodiment together with the attached drawings for the detailed description of the invention.

### BRIEF DESCRIPTION OF THE DRAWINGS

FIG. 1 is a schematic perspective view of a conventional thermal conduction structure for heat generating components;
FIG. 2 is a schematic perspective view of the present invention;
FIG. 3 is an exploded view of the present invention;
FIG. 4 is a partial enlarged view of the present invention; and
FIG. 5 is a cross-sectional 1 view of the present invention.

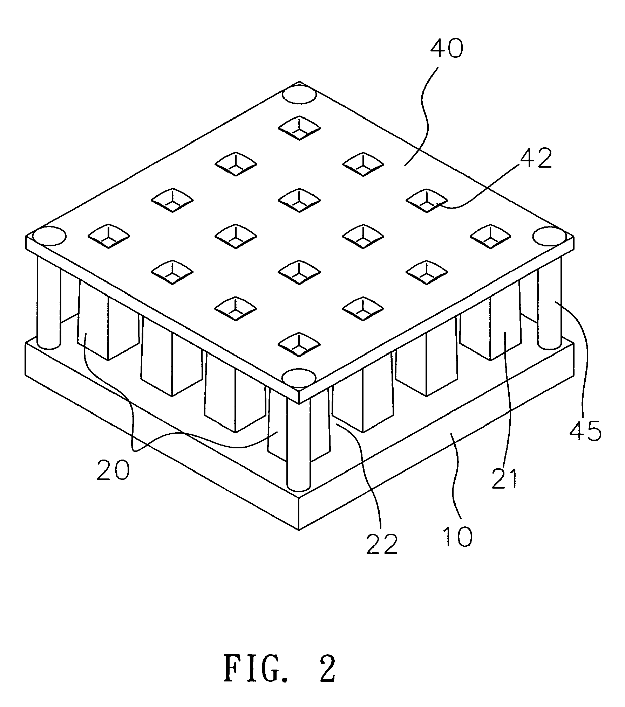

The representative drawing of the invention is FIG 2.

Numerals for respective elements in the drawings are given below:

| | | | |
|---|---|---|---|
| 10 | Heat conduction base | 11 | Fixing hole |
| 20 | Heat conduction module | 21 | Heat column |
| 22 | Gap | 30 | Heat generating component |
| 31 | Electrode | 40 | Pad |
| 41 | Fixing hole | 42 | Penetrating hole |
| 43 | Electric circuit | 44 | Light transmitting element |
| 45 | Fixing element | | |

### DETAILED DESCRIPTION OF THE PREFERRED EMBODIMENTS

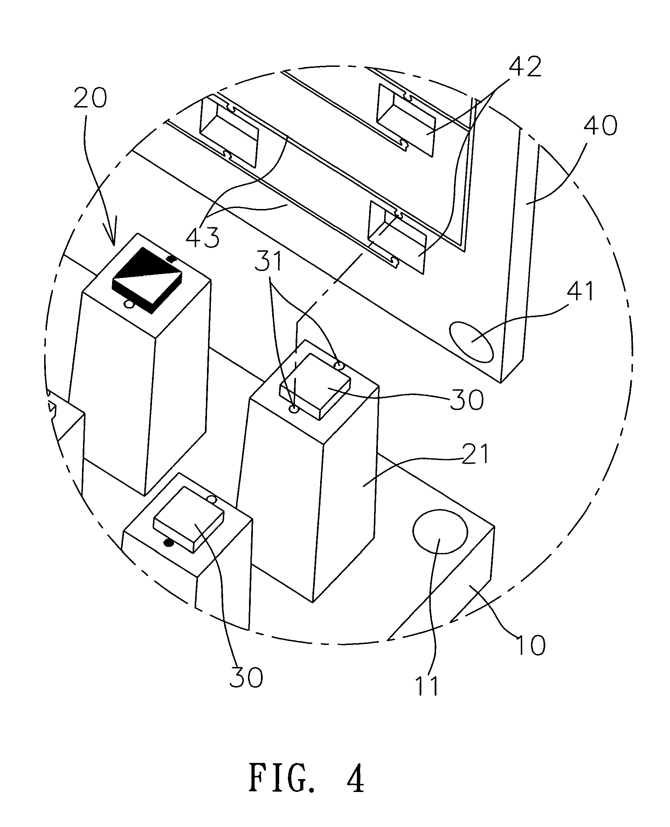

With reference to FIGS. 2 to 4 for a thermal conduction structure for heat generating components in accordance with the present invention, the thermal conduction structure comprises a heat conduction base 10, a heat conduction module 20, a plurality of heat generating components 30 and a pad 40.

The heat conduction base 10 in this preferred embodiment is substantially in the shape of a panel and made of a metal, a ceramic material or a high thermal conductive composite material, and the heat conduction base 10 includes a plurality of fixing holes 11 formed at the periphery of the heat conduction base 10.

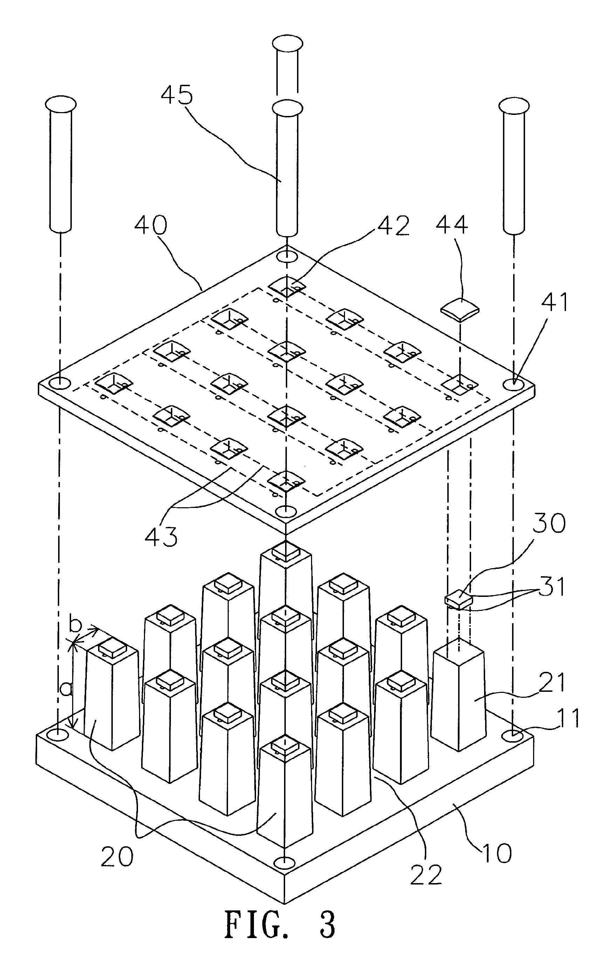

The heat conduction module 20 is installed on the heat conduction base 10, and the heat conduction module 20 includes a plurality of heat columns 21 substantially in a long or flat cylindrical shape (in other words, the heat column has a longitudinal height (a) greater than or equal to any side (b) of a transversal cross-section, or diameters (a≧ b)) as shown in FIG. 3, and the heat columns 21 are installed with a gap 22 apart from each other, and the heat columns 21 can be made of a metal, a ceramic material or a high thermal conductive composite material, wherein the plurality of heat columns 21 are integrally formed with the heat conduction base 10 in this preferred embodiment.

The heat generating component 30 is installed at a distal surface of the heat column 21. In other words, the heat generating component 30 is installed on a distal surface at another end of the heat column 21 with respect to the heat conduction base 10, and at least one heat generating component 30 is installed on a distal surface of each of the heat columns 21, wherein the heat generating component 30 can be an LED chip, an LED package, a LD package, an optoelectronic light source or any other heat source, and an electrode 31 is coupled to a side of the heat generating component 30.

The pad 40 is covered onto the heat conduction module 20 (or the plurality of heat columns 21), and the pad 40 is a circuit board in this preferred embodiment. The pad 40 includes a plurality of fixing holes 41 formed at the periphery of the pad 40 and a plurality of penetrating holes 42 formed on an internal side of the pad 40, and each penetrating hole 42 is covered by a light transmitting element 44 (which is formed by coating a transparent silicone, resin, glass or plastic material in this preferred embodiment), and the light transmitting element 44 can also be doped with a luminescent material such as an organic phosphor, a luminescent pigment, an inorganic phosphor, a wavelength conversion material or a light enhancement material. In addition, the pad 40 further includes an electric circuit 43 (installed on a surface opposite to the heat column 21).

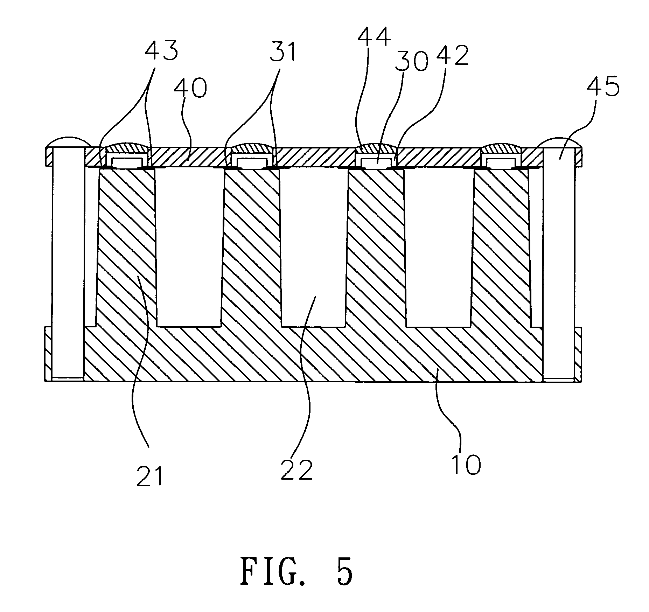

With reference to FIG. 5, when the thermal conduction structure for heat generating components of the present invention is assembled, each heat generating component 30 is fixed onto the heat column 21, and then the pad 40 is passed through the fixing hole 41 and fixed into the fixing hole 11 of the heat conduction base 10 by a fixing element 45 (such as a bolt). Now, the pad 40 is covered onto the heat conduction module 20 (or the plurality of heat columns 21), such that the heat generating component 30 is disposed in the penetrating hole 42 and corresponds to the electric circuit 43 and electrically coupled with the electrode 31, and the plurality of heat generating components 30 are electrically connected in series with one another. If electric power is connected, the light source of the heat generating component 30 will be projected from the penetrating hole 42 through the light transmitting element 44 to provide an illumination effect.

When the conduction structure for heat generating components of the present invention thermal is used, and since the heat columns 21 are installed with a gap apart from each other, a minor portion of the heat source produced by the heat generating component 30 can be dissipated and spreaded from the heat columns 21, and a major portion of the heat source is shunted and conducted from the heat columns 21 to the heat conduction base 10, and finally the heat source is dissipated and eliminated from the heat conduction base 10, so as to provide an excellent shunt and conduction path of the heat source as well as an excellent heat dissipation effect.

After a heat source (which is the heat produced by the heat generating component 30 or related electronic components) is produced, a plurality of independent heat columns 21 are provided for shunting, conducting, dissipating and spreading the heat generated by the heat source, such that a high-heat area or a thermal interference area will not formed at the positions of the plurality of heat generating components 30. The invention can maintain a normal operation of the thermal conduction effect, without affecting the normal function or life of the heat generating component 30, and thus the invention can overcome the shortcomings of the conventional thermal conduction structure and provide an excellent thermal conduction.

In summation of the description above, the present invention complies with the patent application requirements, and thus is duly filed for patent application. While the invention has been described by means of specific embodiments, numerous modifications and variations could be made thereto by those skilled in the art without departing from the scope and spirit of the invention set forth in the claims.

## Claims

1. A thermal conduction structure for heat generating components, comprising:
a heat conduction base 10;
a heat conduction module 20, installed on the heat conduction base 10, and
including a plurality of heat columns 21, and each heat column 21 being in a long or flat cylindrical shape; and
a plurality of heat generating components 30, installed on distal surfaces of the heat columns 21 respectively for passing heat of a heat source produced by each of the heat generating components 30 to the heat conduction base 10 through each of the corresponding heat columns 21 to shunt, conduct, dissipate and eliminate the heat.

2. The thermal conduction structure for heat generating components as recited in claim 1, wherein the plurality of heat columns 21 are installed with a gap 22 apart from each other and disposed on the heat conduction base 10, and the plurality of heat generating components 30 are installed on the heat columns 21 respectively.

3. The thermal conduction structure for heat generating components as recited in claim 1, wherein the heat conduction base 10 or the heat column 21 is made of a metal, a ceramic material or a high thermal conductive composite material.

4. The thermal conduction structure for heat generating components as recited in claim 1, wherein the heat column 21 is integrally formed with the heat conduction base 10.

5. The thermal conduction structure for heat generating components as recited in claim 1, wherein the heat generating component 30 is one selected from the collection of an LED chip, an LED package, a LD package, a Solar Cell package and an optoelectronic light source.

6. The thermal conduction structure for heat generating components as recited in claim 2, further comprising a pad 40 covered onto the top of the heat conduction module 20, and the pad 40 including a plurality of penetrating holes 42 for accommodating the heat generating components 30 respectively.

7. The thermal conduction structure for heat generating components as recited in claim 6, wherein the penetrating hole 42 is covered by a light transmitting element 44.

8. The thermal conduction structure for heat generating components as recited in claim 7, wherein the light transmitting element 44 is made of a material selected from the collection of transparent silicone, resin, glass and plastic.

9. The thermal conduction structure for heat generating components as recited in claim 8, wherein the light transmitting element 44 contains a luminescent material.

10. The thermal conduction structure for heat generating components as recited in claim 9, wherein the luminescent material is one selected from the collection of an organic phosphor, a luminescent pigment, an inorganic phosphor, a wavelength conversion material and a light enhancement material.

11. The thermal conduction structure for heat generating components as recited in claim 6, wherein the pad 40 includes an electric circuit 43 installed on a surface of the pad 40, and each of the heat generating components 30 includes an electrode 31 electrically coupled to the electric circuit 43.

12. The thermal conduction structure for heat generating components as recited in claim 6, wherein the heat conduction base 10 and the pad 40 include corresponding fixing holes 41 formed at the periphery of the heat conduction base 10 and the pad 40, and fixed by a fixing element 45.
